# EUROPEAN PATENT APPLICATION

(11) **EP 2 645 417 A1**
(43) Date of publication of application: **02.10.2013**
(21) Application number: 13157205.9
(22) Date of filing: 28.02.2013
(51) Int. Cl.: H01L 25/03, H01L 25/065

(54) **Semiconductor module**

(30) Priority: 30.03.2012 JP 2012080570
(71) Applicant: J-Devices Corporation, Usuki-shi, Oita (JP)
(72) Inventor: Umeki, Akihiro, Kanagawa 212-8583 (JP); Hiruta, Yoichi, Oita 873-0002 (JP)
(74) Representative: Schwabe - Sandmair - Marx

(57) **Abstract**

In the semiconductor module comprising a package substrate, a first semiconductor package, and a semiconductor bare chip, such problems as the occurrence of a wire short caused by warpage of the first semiconductor package and non-filling and the like at the time of resin sealing can be solved.

A semiconductor module (10), having: a semiconductor package (6), which is obtained by mounting and resin-sealing a semiconductor bare chip (1) on a first package substrate (4); a semiconductor bare chip 2; and a second package substrate (12), the semiconductor module being characterized in that the semiconductor package (6) is mounted on the second package substrate (12) and the semiconductor bare chip (2) is mounted on the semiconductor package (6).

## Description

### BACKGROUND OF THE INVENTION

### 1. Field of the Invention

The present invention relates to a semiconductor module obtained by stacking a semiconductor bare chip and a semiconductor package.

### 2. Description of the Related Art

Due to the demands for high-functionalization and reduction in weight, thickness, length, and size of recent electronics, electronic components have increasingly been sought for high-density integration and high-density packaging, and semiconductor devices used in these electronics are becoming smaller and smaller than before.

As a method for reducing the size of a semiconductor device, there exists an SOC (SOC: System-on-a-chip) technology for reducing the packaging area by microfabricating one semiconductor bare chip and integrating all functions necessary into a single chip, thereby lowering power consumption. However, this method increases production costs due to making the circuit small, and a diffusion process is so complicated that the production work period becomes long, and the production yielding cannot be increased.

A SIP (System In Package) technology has attracted attention as an alternative method. According to the SIP, a plurality of semiconductor bare chips of different functions are produced under respective optimized manufacturing conditions, which are then packaged and wired appropriately on a package, and therefore an integrated circuit having a more advanced function can be stably produced.

Incidentally, in the SIP having a plurality of semiconductor bare chips stored in one package as described above, each of the semiconductor bare chips is, in the light of yielding, required to be a semiconductor bare chip that is inspected in advance and confirmed as a non-defective product (KGD: Known Good Die).

In order to obtain the KGD, in a state of a semiconductor wafer form or in a state in which a semiconductor wafer is diced and perfectly separated into individual semiconductor bare chips, probe examination is performed by applying a probe on an electrode provided on a surface of each of the semiconductor bare chips, the semiconductor bare chips are then sorted based on the examination result, and burn-in test or other screening examination is performed only on a selected non-defective semiconductor bare chip.

A problem, however, is that when the probe examination is performed directly on the semiconductor bare chips, an individual semiconductor bare chip or the semiconductor wafer becomes cracked. Furthermore, a socket, probe, tester and the like used in the examination cannot be operated easily.

In order to solve the problem described above, there is proposed a semiconductor device in which a surface of a resin sealing package, obtained by sealing a semiconductor bare chip with resin, is provided with an electrode connected to an electrode of the semiconductor bare chip and a test electrode connected to a testing unit (refer to Japanese Patent Publication No. 2002-40095). Because this semiconductor device is configured as a package prior to being packaged in a mount board, an advantage thereof is that examination can be performed using an inexpensive examination socket without causing the problem of breaking the chips and other problems.

There is also proposed a semiconductor module that is configured as an SIP by using the packaged semiconductor device described above (refer to Japanese Patent Publication No. 4303772).

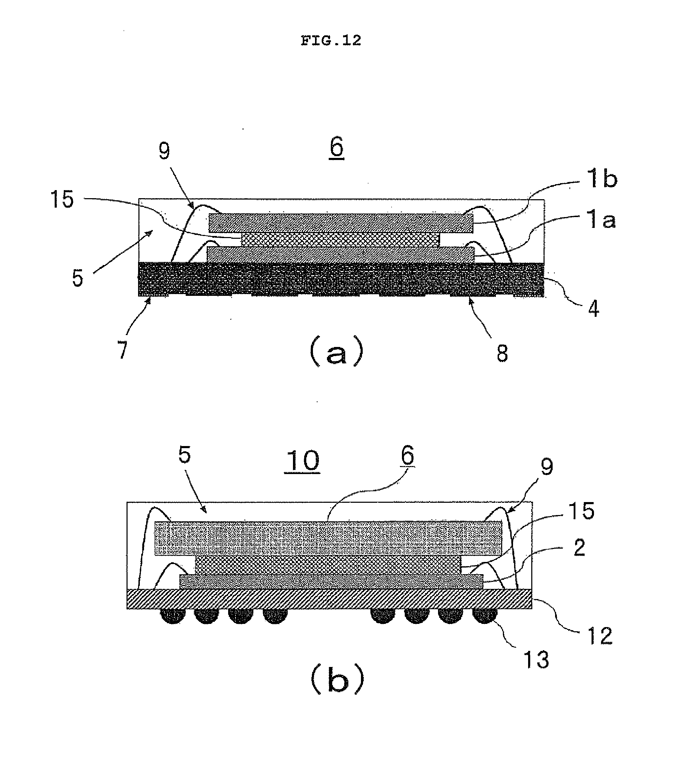

This semiconductor module is shown in Fig. 12.

Fig. 12A shows a first semiconductor package 6 that is obtained by mounting a semiconductor bare chip 1a on an interposer 4, stacking a spacer 15 thereon, further stacking a semiconductor bare chip 1b thereon, disposing a wire 9 by means of wire bonding, and resin-sealing the resultant product by means of resin 5.

Fig. 12B shows a SIP semiconductor module 10 in which a product, obtained by stacking a semiconductor bare chip 2, a spacer 15, and the abovementioned first semiconductor package 6 on a package substrate 12 in this order, is resin-sealed.

Note that, in the illustrated example, because the first semiconductor package 6 and the semiconductor bare chip 2 are substantially the same size, the spacer 15 is inserted between the first semiconductor package 6 and the semiconductor bare chip 2 so that an electrode pad of the semiconductor bare chip 2 is not hidden.

Moreover, US Patent Publication No. 7057269 describes that a semiconductor bare chip is mounted and resin-sealed on a package substrate to obtain a first semiconductor package, and thereafter a second semiconductor package is mounted to form a semiconductor module.

However, such a semiconductor module incurs a cost increase and decrease in yield as a result of taking complicated steps and is not suitable for reducing the thickness of the package. Furthermore, in the semiconductor module configured by a tested semiconductor package stacked on the abovementioned first semiconductor package, technical problems are that the tested first semiconductor package comes into contact with a wire of the lower package as a result of a warpage variation based on the assembly heat history, causing a wire short, and an overhang occurs because the lower package is smaller than the tested package, resulting in non-filling and the like at the time of resin sealing.

### SUMMARY OF THE INVENTION

### 1. Problems to be Solved by the Invention

An object of the present invention is, in a semiconductor module comprising a package substrate, a first semiconductor package, and a semiconductor bare chip, to solve such problems as the occurrence of a wire short caused by warpage of the first semiconductor package and non-filling and the like at the time of resin sealing.

### 2. Means for Solving the Problems

In the semiconductor module comprising a package substrate, a first semiconductor package, and a semiconductor bare chip, the inventors of the present invention found out that the problems described above can be solved and completed the present invention by mounting the first semiconductor package, equipped with a semiconductor bare chip and sealed with resin, on the package substrate, mounting the semiconductor bare chip on the first semiconductor package, and resin-sealing the first semiconductor package and the semiconductor bare chip.

In other words, the present invention is described as follows.

(1) A semiconductor module, having: a semiconductor package, which is obtained by mounting and resin-sealing a semiconductor bare chip on a first package substrate; a semiconductor bare chip; and a second package substrate, the semiconductor module being **characterized in that** the semiconductor package is mounted on the second package substrate and the semiconductor bare chip is mounted on the semiconductor package.

(2) The semiconductor module described in (1), **characterized in that** the semiconductor package is electrically connected to the second package substrate by solder via an electrode pad on a surface on the side opposite to a resin surface.

(3) The semiconductor module described in (1), **characterized in that** the semiconductor package is bonded to the second package substrate at the resin surface and electrically connected to the second package substrate by wire bonding.

(4) The semiconductor module described in any of (1) to (3), **characterized in that** the semiconductor bare chip mounted on the semiconductor package is electrically connected to the second package substrate by wire bonding.

(5) The semiconductor module described in any of (1) to (4), **characterized in that** two or more of the semiconductor bare chips are stacked and mounted on the semiconductor package and an electrical connection between the semiconductor bare chips has a COC structure.

(6) The semiconductor module described in any of (1) to (4), **characterized in that** two or more of the semiconductor bare chips are stacked and mounted on the semiconductor package and the semiconductor bare chips are electrically connected to each other by wire bonding.

(7) The semiconductor module described in any of (1) to (6), **characterized in that** the semiconductor bare chip is mounted on the semiconductor package, with a spacer therebetween.

(8) The semiconductor module described in any of (1) to (7), **characterized in that** a heatsink is mounted on the semiconductor bare chip.

(9) The semiconductor module described in any of (1) to (8), **characterized in that** the semiconductor package has a plurality of the semiconductor bare chips mounted on the first package substrate.

### [Effects of the Invention]

According to the present invention, because the first semiconductor package is mounted on the package substrate, a warpage variation of the first semiconductor package based on a heat history in a subsequent assembly step can be suppressed.

Therefore, such problems as the occurrence of a wire short caused by warpage of the first semiconductor package and non-filling and the like at the time of resin sealing can be solved. Moreover, a package cross-sectional size that does not consider the warpage variation of the first semiconductor package can be obtained, and reduction in thickness of the package can be realized.

### DETAILED DESCRIPTION OF THE PREFERRED EMBODIMENTS

Modes for carrying out the present invention are described hereinafter. Note that the embodiments are described hereinafter based on the diagrams, but these diagrams are provided for purposes of illustration, and the present invention is not to be limited to these diagrams.

A semiconductor module according to the present invention is obtained by resin-sealing and packaging a package substrate, a first semiconductor package mounted on this package substrate, and a semiconductor bare chip stacked on this first semiconductor package.

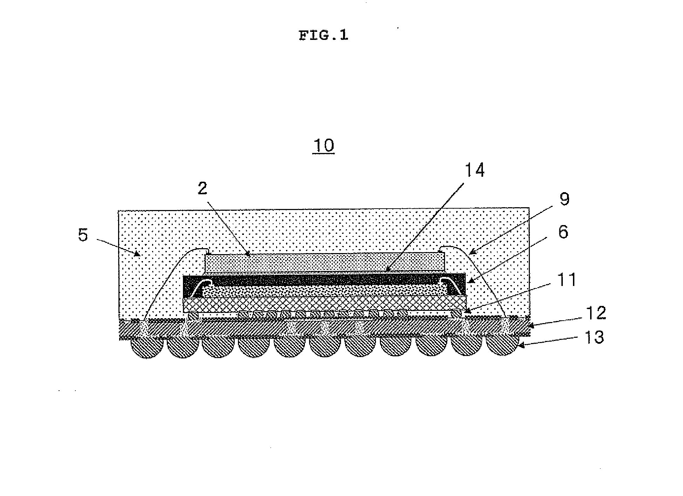

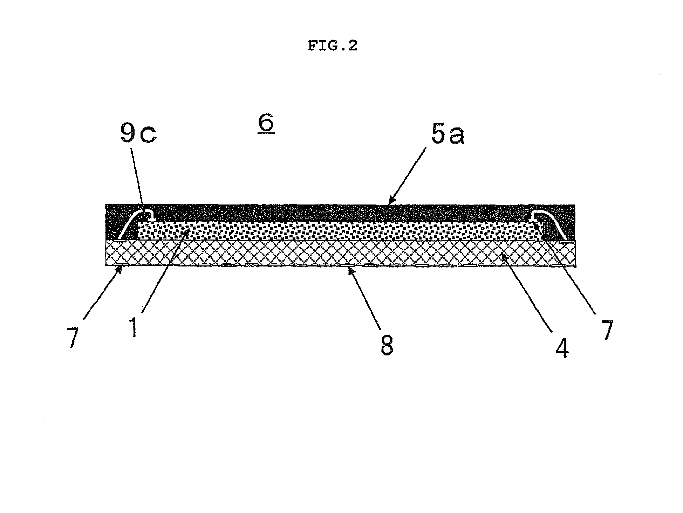

A basic configuration of the semiconductor module of the present invention is described hereinafter with reference to Figs. 1, 2.

Hereinafter, the package substrate of the first semiconductor package is often referred to as first package substrate and the package substrate equipped with this first semiconductor package is often referred to as second package substrate. In addition, the semiconductor module of the present invention that has the first semiconductor package is often referred to as second semiconductor package.

### (Embodiment 1)

Fig. 1 is a diagram showing a semiconductor module 10 of Embodiment 1 of the present invention.

The semiconductor module 10 according to the present invention is obtained by resin-sealing a package substrate (also referred to as second package substrate hereinafter) 12, a first semiconductor package 6 mounted on this package substrate 12, and a semiconductor bare chip 2 stacked on this first semiconductor package 6, by means of resin 5.

The first semiconductor package 6 is described in detail based on Fig. 2.

The first semiconductor package 6 is obtained by mounting a semiconductor bare chip 1 on a first package substrate 4, electrically connecting the semiconductor bare chip 1 and the first package substrate 4 to each other by wire bonding using a wire 9c, and thereafter resin-sealing the resultant product with resin 5a.

A product that is considered non-defective as a result of a wafer-level test is used as the semiconductor bare chip 1. Furthermore, a product that is considered non-defective as a result of a package-state test is used as the first semiconductor package 6. Note that the fact that the tests are carried out is not necessarily definitive.

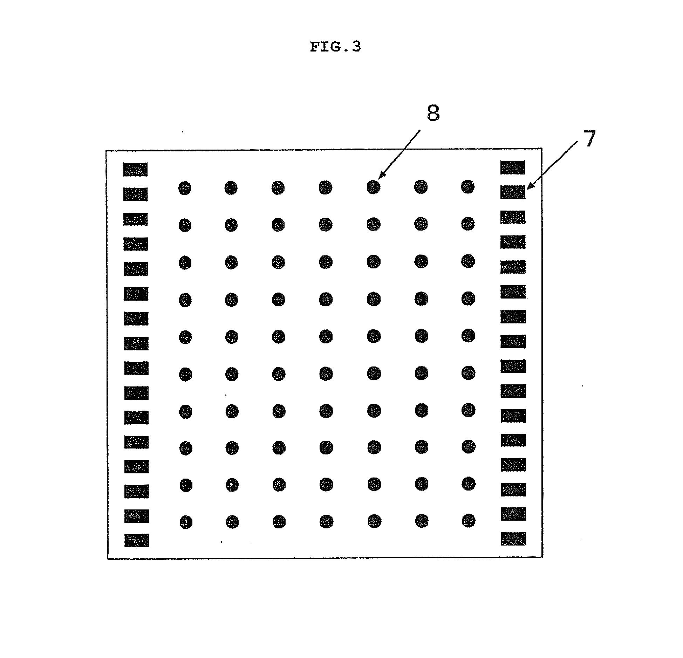

Fig. 3 is a diagram showing an exterior of the first package substrate 4. The first package substrate 4 has a mounting electrode 7 and a test electrode 8.

In the present embodiment, first, the first semiconductor package 6 is mounted on the second package substrate 12, as shown in Fig. 1. This mounting process is carried out by bonding the electrode pads 7 and 8 of the first package substrate 4 of the first semiconductor package 6 to electrodes of the package substrate 12 by solder. Subsequently, the semiconductor bare chip 2 is mounted on a resin surface of this first semiconductor package 6 by being bonded thereto using an adhesive 14, then the semiconductor bare chip 2 and the second package substrate 12 are electrically connected to each other by a wire 9, and thereafter the first semiconductor package 6 and the semiconductor bare chip 2 are sealed with the resin 5, thereby obtaining a second semiconductor package (semiconductor module).

In a conventional example shown in Fig. 12B, because a wire is disposed in a gap between the semiconductor bare chip 2 and the first semiconductor package 6, the problem is that warpage of the first semiconductor package 6 causes deformation of the wire and hence a wire short, or the gap becomes narrow, preventing the resin from covering the gap. However, in the present embodiment, because the first semiconductor package 6 is bonded to the package substrate 12 with solder via the electrodes 7 and 8, warpage of the first semiconductor package 6 can be corrected and the warpage can be prevented from occurring.

Moreover, because the semiconductor bare chip 2 is located on the uppermost level, wire-bonding operation is easy, and such problems as a wire short or formation of a resin non-filling section do not occur.

In addition, while the test electrode 8 of the first package substrate 4 is used only for a test in the conventional example, the present embodiment is advantageous in that, when solder-bonding the first package substrate and the second package substrate through the electrodes, the test electrode 8 can be used as a mounting electrode by appropriately designing the wiring of the second package substrate.

### (Embodiment 2)

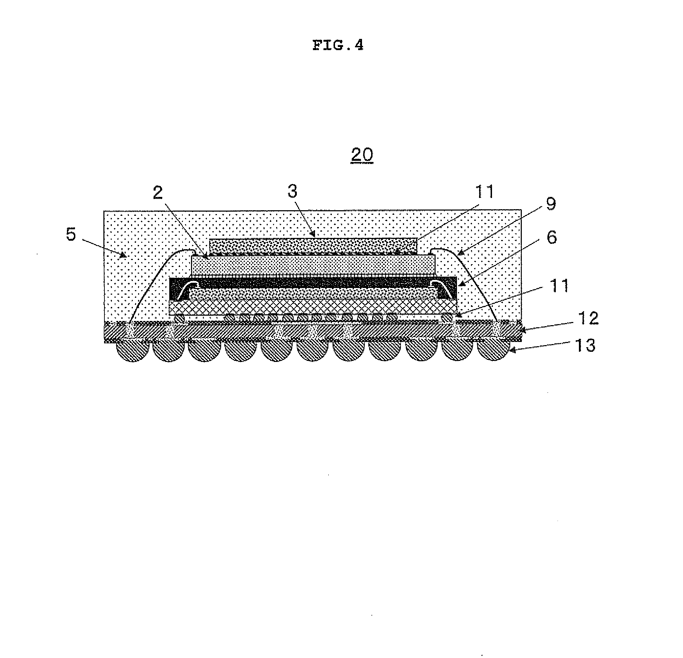

Fig. 4 shows a semiconductor module 20 of Embodiment 2 of the present invention.

As with Embodiment 1, in the present embodiment, the first semiconductor package 6 is mounted on the package substrate 12 by bonding the electrode pads 7 and 8 of the first package substrate 4 to the electrodes of the package substrate 12 by means of solder. The first semiconductor bare chip 2 is mounted on the resin surface of the first semiconductor package 6, and a second semiconductor bare chip 3 is further mounted on this first semiconductor bare chip 2. The first semiconductor bare chip 2 and the second semiconductor bare chip 3 are directly connected to each other by metal bonding such as soldering, which is so-called a COC (Chip On Chip) connection structure with fine-pitch connection.

### (Embodiment 3)

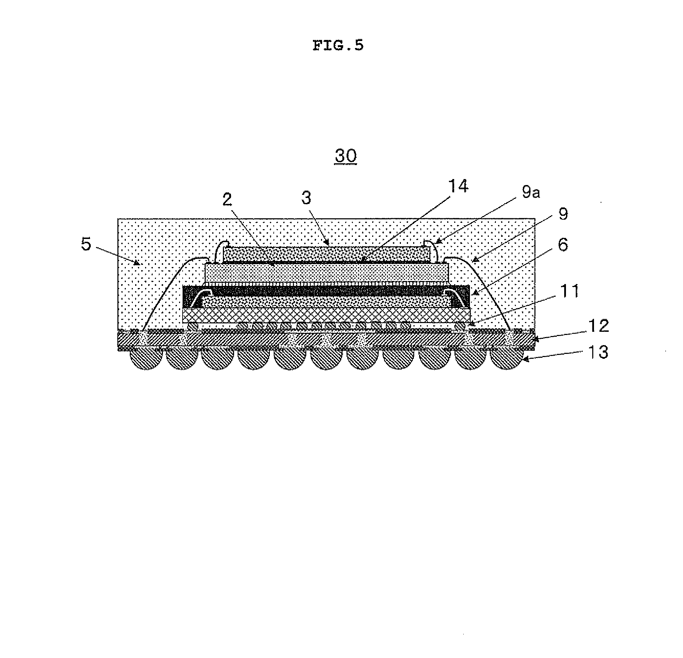

Fig. 5 is a diagram showing a semiconductor module 30 of Embodiment 3 of the present invention.

As with Embodiment 1, in the present embodiment, the first semiconductor package 6 is mounted on the second package substrate 12 by bonding the electrode pads 7 and 8 of the first package substrate 4 of the first semiconductor package 6 to the electrodes of the second package substrate 12 by means of solder. The first semiconductor bare chip 2 is mounted on the resin surface of the first semiconductor package 6 by an adhesive, and the second semiconductor bare chip 3 is further mounted thereon by an adhesive. The first semiconductor bare chip 2 and the second semiconductor bare chip 3 are electrically connected to each other by a wire 9a, and the first semiconductor bare chip 2 and the second package substrate 12 are electrically connected to each other by the wire 9. Note that the second semiconductor bare chip 3 is sometimes electrically connected to the second package substrate 12 directly by the wire 9a.

### (Embodiment 4)

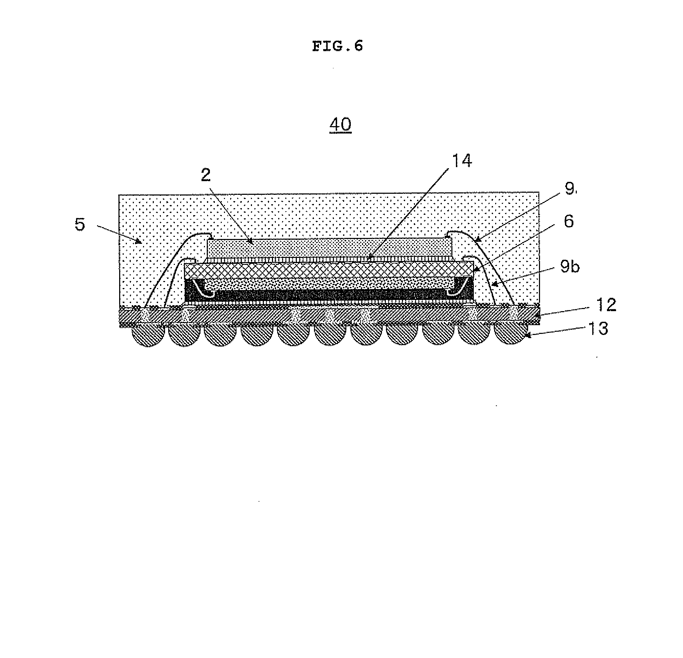

Fig. 6 is a diagram showing a semiconductor module 40 of Embodiment 4 of the present invention.

In the present embodiment, the first semiconductor package 6 and the second package substrate 12 are bonded to each other by an adhesive such that the resin surface side of the first semiconductor package 6 faces the second package substrate side. The warpage of the first semiconductor package 6 can be corrected and the warpage can be prevented from occurring, by, in the manner described above, bonding the first semiconductor package 6 and the second package substrate 12 to each other such that the resin surface side of the first semiconductor package 6 faces the second package substrate side.

The semiconductor bare chip 2 is bonded to and mounted on a surface on the side opposite to the resin surface of this first semiconductor package 6 by the adhesive 14. This first semiconductor package is electrically connected to the second package substrate 12 by a wire 9b, and the semiconductor bare chip 2 is electrically connected to the second package substrate 12 by the wire 9.

### (Embodiment 5)

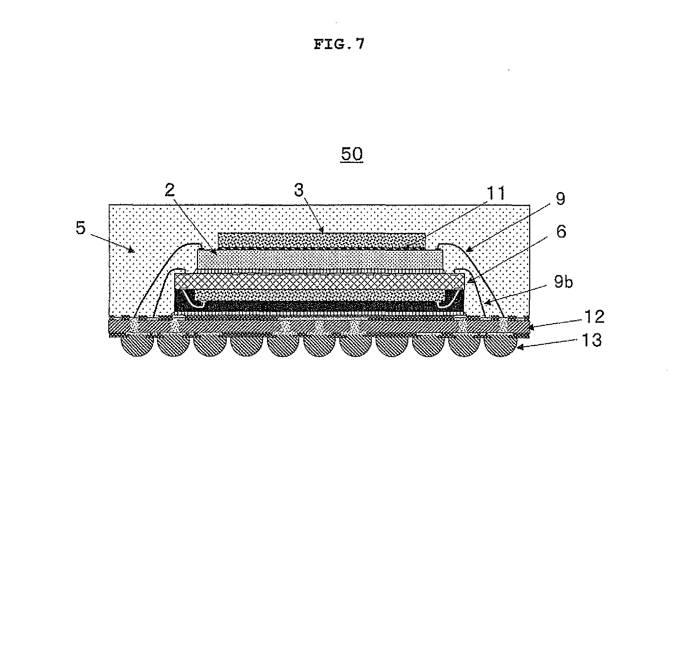

Fig. 7 is a diagram showing a semiconductor module 50 of Embodiment 5 of the present invention.

In the present embodiment, the first semiconductor package 6 and the second package substrate 12 are bonded to each other by an adhesive such that the resin surface side of the first semiconductor package 6 faces the second package substrate side. The first semiconductor bare chip 2 is mounted on the surface on the side opposite to the resin surface of the first semiconductor package 6. Further, the second semiconductor bare chip 3 is mounted on this first semiconductor bare chip 2. The first semiconductor bare chip 2 and the second semiconductor bare chip 3 are directly electrically connected to each other by metal bonding using solder 11 or the like.

Also, the first semiconductor package 6 is electrically connected to the second package substrate 12 by the wire 9b, and the first semiconductor bare chip 2 is electrically connected to the second package substrate 12 by the wire 9.

### (Embodiment 6)

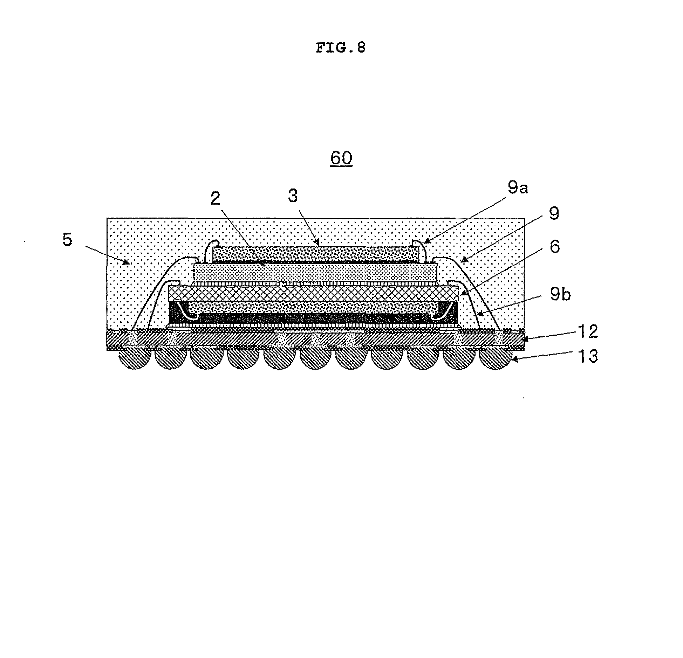

Fig. 8 is a diagram showing a semiconductor module 60 of Embodiment 6 of the present invention.

In the present embodiment, the first semiconductor package 6 and the second package substrate 12 are bonded to each other by an adhesive such that the resin surface side of the first semiconductor package 6 faces the second package substrate side. The first semiconductor bare chip 2 is bonded to and mounted on the surface on the side opposite to the resin surface of the first semiconductor package by an adhesive, and the second semiconductor bare chip 3 is bonded to and mounted on this first semiconductor bare chip 2 by an adhesive. The first semiconductor bare chip 2 and the second semiconductor bare chip 3 are electrically connected to each other by the wire 9a, the first semiconductor bare chip 2 and the second package substrate 12 are electrically connected to each other by the wire 9, and the first semiconductor package 6 and the second package substrate 12 are electrically connected to each other by the wire 9b. Note that the second semiconductor bare chip 3 sometimes electrically connected directly to the second package substrate 12 by the wire 9a.

### (Embodiment 7)

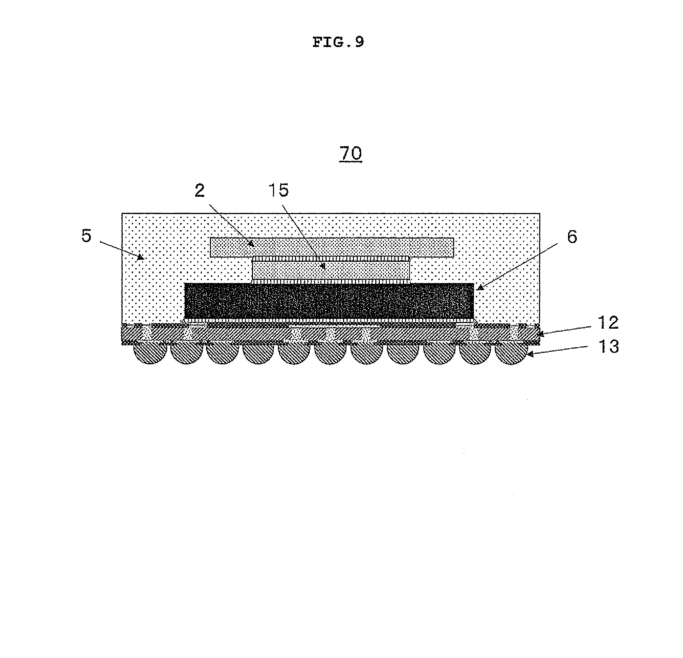

Fig. 9 is a diagram showing a semiconductor module 70 of Embodiment 7 of the present invention.

In the present embodiment, a spacer 15 is mounted on the first semiconductor package 6, and the semiconductor bare chip 2 is mounted thereon. Note that neither the electrical connection structure between the first semiconductor package 6 and the second package substrate 12 nor the electrical connection structure between the semiconductor bare chip 2 and the second package substrate 12 is shown in Fig. 9. The first semiconductor package 6 and the second package substrate 12 may be bonded to each other on the electrode side of the first semiconductor package 6 or may be bonded to each other on the resin surface side of the first semiconductor package 6.

Providing the spacer 15 can wire-bond the first semiconductor package 6 and the package substrate 12 to each other even when there is no difference in size between the semiconductor bare chip 2 and the first semiconductor package 6.

### (Embodiment 8)

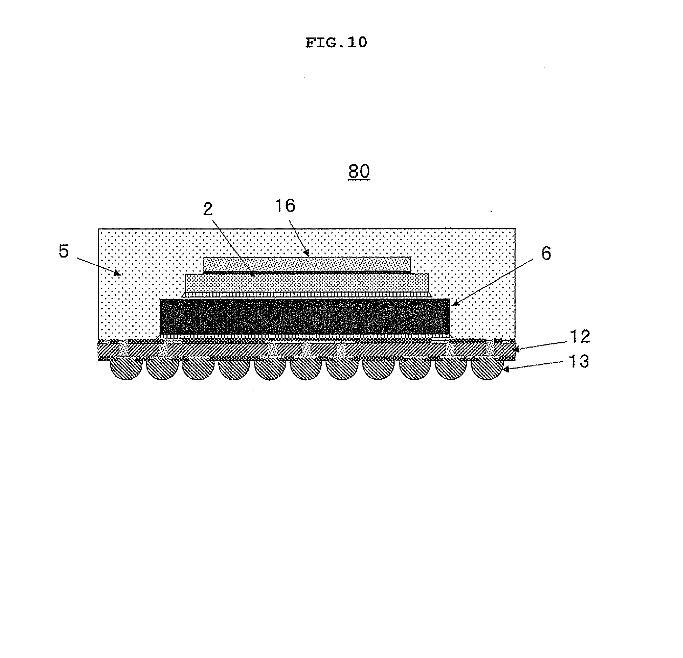

Fig. 10 is a diagram showing a semiconductor module 80 of Embodiment 8 of the present invention.

In the present embodiment, the semiconductor bare chip 2 is mounted on the first semiconductor package 6, and a heatsink 16 such as a silicon plate or Cu plate is mounted on this semiconductor bare chip 2.

In the illustrated example, the heatsink 16 is mounted on the semiconductor bare chip; however, the position to provide the heatsink 16 is not limited to the top of the semiconductor bare chip 2.

Note that neither the electrical connection structure between the first semiconductor package 6 and the package substrate 12 nor the electrical connection structure between the semiconductor bare chip 2 and the package substrate 12 is shown in Fig. 10.

The first semiconductor package 6 and the second package substrate 12 may be bonded to each other on the electrode side of the first semiconductor package 6 or may be bonded to each other on the resin surface side of the first semiconductor package 6.

Providing such heatsink 16 can enhance the heat dissipation characteristics of the semiconductor module.

### (Embodiment 9)

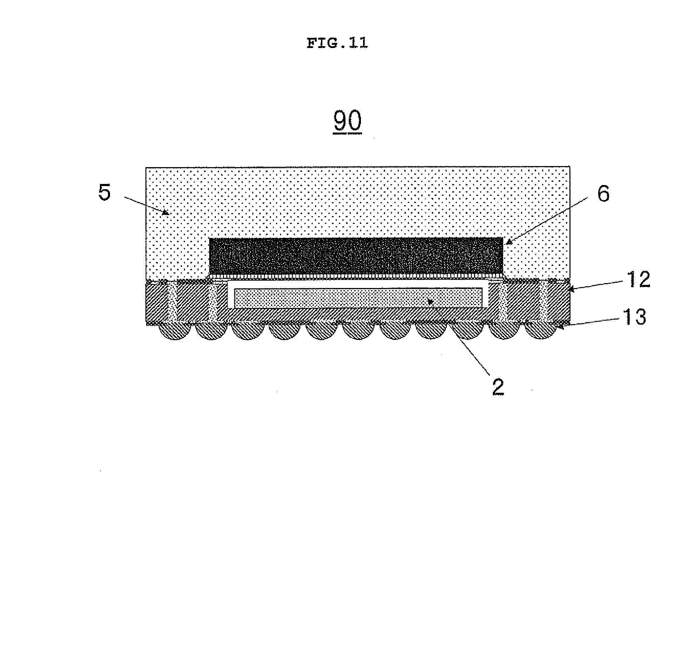

Fig. 11 is a diagram showing a semiconductor module 90 of Embodiment 9 of the present invention.

In the present embodiment, the semiconductor bare chip 2 is packaged in the second package substrate 12, which is sealed with the resin 5 after bonding the first semiconductor package 6 to this second package substrate 12, to obtain the semiconductor module 90.

According to this embodiment, because the thickness of the semiconductor bare chip 2 can be absorbed in the second package substrate 12, the semiconductor module 90 can be made thin.

## Claims

1. A semiconductor module, having: a semiconductor package, which is obtained by mounting and resin-sealing a semiconductor bare chip on a first package substrate; a semiconductor bare chip; and a second package substrate, the semiconductor module being **characterized in that** the semiconductor package is mounted on the second package substrate and the semiconductor bare chip is mounted on the semiconductor package.

2. The semiconductor module according to claim 1, **characterized in that** the semiconductor package is electrically connected to the second package substrate by solder via an electrode pad on a surface on the side opposite to a resin surface.

3. The semiconductor module according to claim 1, **characterized in that** the semiconductor package is bonded to the second package substrate at the resin surface and electrically connected to the second package substrate by wire bonding.

4. The semiconductor module according to claims 1 through 3, **characterized in that** the semiconductor bare chip mounted on the semiconductor package is electrically connected to the second package substrate by wire bonding.

5. The semiconductor module according to claims 1 through 4, **characterized in that** two or more of the semiconductor bare chips are stacked and mounted on the semiconductor package and an electrical connection between the semiconductor bare chips has a COC structure.

6. The semiconductor module according to claims 1 through 4, **characterized in that** two or more of the semiconductor bare chips are stacked and mounted on the semiconductor package and the semiconductor bare chips are electrically connected to each other by wire bonding.

7. The semiconductor module according to claims 1 through 6, **characterized in that** the semiconductor bare chip is mounted on the semiconductor package, with a spacer therebetween.

8. The semiconductor module according to claims 1 through 7, **characterized in that** a heatsink is mounted on the semiconductor bare chip.

9. The semiconductor module according to claims 1 through 8, **characterized in that** the semiconductor package has a plurality of the semiconductor bare chips mounted on the first package substrate.
